# DEMANDE DE BREVET EUROPEEN

(11) **EP 3 954 802 A1**
(43) Date de publication de la demande: **16.02.2022**
(21) Numéro de dépôt: 20190566.8
(22) Date de dépôt: 11.08.2020
(51) Int. Cl.: C23C 14/00, A44C 17/02, G04B 19/12

(54) **COMPOSANT NOIR DECORE DE PIERRES ET SON PROCEDE DE FABRICATION**

(71) Demandeur: Omega SA, 2502 Biel/Bienne (CH)
(72) Inventeur: JEANRENAUD, Frédéric, 2300 La Chaux-de-Fonds (CH); KISSLING, Gregory, 2520 La Neuveville (CH); LAUPER, Stéphane, 2016 Cortaillod (CH); MARLOT DOERR, Agnès, 2000 Neuchâtel (CH); MIKO, Csilla, 1417 Essertines-sur-Yverdon (CH)
(74) Mandataire: ICB SA

(57) **Abrégé**

La présente invention se rapporte à un composant d'habillage intérieur ou du mouvement pour une pièce d'horlogerie ou de bijouterie comprenant un substrat (2) revêtu partiellement d'une couche noire (3) et décoré d'au moins une pierre (4), ladite couche noire (3) comprenant des nanotubes de carbone ou de l'oxyde d'aluminium, ledit substrat (2) étant au moins dépourvu de la couche noire (3) sur la portion en regard de la pierre (4).

Elle se rapporte également au procédé de fabrication de ce composant d'horlogerie ou de bijouterie.

## Description

### Domaine de l'invention

L'invention se rapporte à un composant destiné à l'habillage intérieur ou au mouvement d'une pièce d'horlogerie ou de bijouterie. Elle se rapporte également au procédé de fabrication dudit composant.

### Arrière-plan de l'invention

La « couleur » noire peut être obtenue dans la masse d'un matériau de par sa couleur intrinsèque ou via l'ajout de pigments ou colorants au sein du matériau. La « couleur » noire peut également être présente uniquement en surface. Cette coloration en surface peut être obtenue de différentes manières, généralement par oxydation/sulfuration/carburation d'un substrat métallique ou par dépôt d'un oxyde/sulfure/carbure sur un substrat. Le carbone est donc un élément bien connu pour noircir une surface. Déposé de manière longiligne sous forme de nanotubes, le matériau formé peut s'approcher d'un corps noir parfaitement absorbant allant jusqu'à donner des coefficients d'absorption de lumière de 99,96% dans le visible et proche infrarouge. Ce noir est si parfait qu'il peut cacher des formes 3D d'un objet vu de face.

L'utilisation de revêtements noirs est connue dans le domaine horloger. Du document EP 3 327 517, on connait un cadran avec un premier substrat revêtu d'une couche noire de nanotubes faisant face au verre de montre et avec un deuxième substrat fixé au premier substrat sur la surface opposée au verre. Le premier substrat est ajouré afin de réaliser des ouvertures faisant office de fenêtres destinées à former des index. Le deuxième substrat comprend un revêtement luminescent au moins dans les zones en regard des ouvertures de manière à créer un contraste au niveau du premier substrat entre la couche noire et les index illuminés.

Ainsi, le contraste est obtenu via la superposition de deux substrats présentant des revêtements distincts. Cette superposition permet d'éviter de déposer de manière sélective l'un et l'autre revêtement sur une même surface et de manipuler plus que nécessaire la couche de nanotubes qui est particulièrement fragile. Cette superposition a néanmoins pour inconvénient de requérir la fabrication de deux substrats ce qui augmente les coûts de production.

Du document CH 711 141, on connaît un procédé de fabrication d'un cadran où le décor, à savoir des index, est apposé sur le revêtement en noir de carbone. Le décor est fabriqué séparément du cadran et ensuite simplement rapporté ce qui permet de faciliter grandement la fabrication du cadran. Cette technique de fabrication est cependant inadaptée pour certains types de décors où la couleur noire sous-jacente au décor impacte l'esthétique et/ou la brillance du décor.

En particulier, cette technique de fabrication est peu adaptée pour un décor formé de pierres, en particulier de diamants. La difficulté réside dans le sertissage des pierres sur le cadran revêtu d'une couche noire. Cette dernière doit être discontinue au niveau des pierres sous peine de dégrader la brillance des pierres, tout en enrobant parfaitement les pierres pour obtenir le contraste escompté. Une attention particulière doit être portée au procédé de fabrication pour ne pas endommager la couche de nanotubes de carbone. La couche peut être à ce point friable qu'il est quasi impossible de la toucher sans dégrader la surface, montrant des voiles brillants voire des trous contrastant avec la couleur originale des nanotubes de carbone.

### Buts de l'invention

Le but de la présente invention est de proposer un procédé de fabrication d'un composant d'horlogerie ou de bijouterie revêtu de noir et décoré de pierres, et plus particulièrement serti de pierres. Ce procédé est mis au point de manière à ne pas endommager le revêtement noir tout en ayant une couche noire discontinue au niveau des pierres.

Le procédé de fabrication selon l'invention ne peut ainsi se contenter de rapporter un décor, en l'occurrence des pierres, sur le revêtement comme selon l'art antérieur. Selon l'invention, le décor formé des pierres est fabriqué directement sur le substrat avec la couche noire enlevée sélectivement de manière à maintenir une surface vierge de noir en dessous du décor.

Plus précisément, l'invention se rapporte à un procédé de fabrication d'un composant destiné à l'habillage intérieur ou au mouvement d'une pièce d'horlogerie ou de bijouterie, ledit composant comportant un substrat revêtu au moins partiellement d'une couche noire comprenant des nanotubes de carbone ou de l'oxyde d'aluminium, le substrat revêtu étant décoré avec au moins une pierre assise dans un logement ménagé dans le substrat, ce dernier étant au moins dépourvu de la couche noire sur la surface du logement, ledit procédé comprenant:
- une étape a) de mise à disposition du substrat,
   suivie dans un ordre non spécifié d'
- une étape b) de dépôt de la couche noire sur le substrat,
- une étape c) d'usinage du logement dans le substrat,
- une étape e) de positionnement et fixation de la pierre au sein du logement,
ledit procédé comprenant une étape additionnelle d) d'enlèvement sélectif de la couche noire préalablement déposée sur le substrat de manière à ce qu'au moins la surface du logement soit dépourvue de la couche noire.

Selon une variante du procédé qui est d'application lorsque la couche noire comporte des nanotubes de carbone, l'étape b) est remplacée par une étape b') de dépôt d'une couche d'un précurseur comportant des nanotubes de carbone. L'étape additionnelle d) est alors remplacée par une étape additionnelle d') d'enlèvement sélectif de la couche de précurseur de manière à ce qu'au moins la surface du logement soit dépourvue de la couche de précurseur. Ce procédé comporte en outre une étape f) qui consiste à réaliser une attaque chimique ou laser de la couche de précurseur afin de révéler la couche noire de nanotubes de carbone.

L'étape d) ou d') d'enlèvement sélectif peut être réalisée mécaniquement, par exemple à l'aide d'un outil de sertisseur, ou préférentiellement par ablation laser. L'enlèvement sélectif peut également être réalisé indirectement lors de l'étape d'usinage du logement ou encore lors d'une étape de croissance d'un support pour la pierre sur le substrat via, par exemple, une opération de fabrication additive et plus précisément de fabrication additive par jet d'encre.

La présente invention se rapporte également au composant d'habillage intérieur ou du mouvement pour une pièce d'horlogerie ou de bijouterie comprenant un substrat revêtu partiellement d'une couche noire et décoré d'au moins une pierre assise dans un logement ménagé dans ou sur le substrat, ladite couche noire comprenant des nanotubes de carbone ou un oxyde d'aluminium, ledit substrat étant au moins dépourvu de la couche noire sur la portion en regard de la pierre ou, en d'autres mots, sur la surface du logement.

Pour un décor de diamants sur un revêtement de nanotubes de carbone, la présente invention propose de réaliser un composant d'horlogerie ou de bijouterie avec en surface deux formes allotropiques du carbone, l'un très noir pour les nanotubes de carbone et l'autre très blanc pour le diamant permettant des contrastes de brillance très marqués.

D'autres caractéristiques et avantages de la présente invention apparaîtront dans la description présentée en référence aux dessins annexés.

### Description sommaire des dessins

La figure 1 est une représentation en plan d'une pièce d'horlogerie munie d'un cadran revêtu et décoré avec des pierres selon le procédé de l'invention. En agrandissement, une pierre avec l'élément de sertissage est représentée.
Les figures 2 à 7 sont des représentations schématiques de différents modes de réalisation du procédé selon l'invention avec les étapes successives mises en œuvre.

### Description de l'invention

L'invention se rapporte à un composant destiné à l'habillage intérieur ou au mouvement d'une pièce d'horlogerie ou de bijouterie. Il peut être choisi parmi la liste non exhaustive comprenant un cadran, une aiguille, un index, une applique, une masse oscillante, une platine, un pont, etc. Selon l'invention, ce composant est au moins partiellement revêtu d'une couche noire. L'invention se rapporte également à un ensemble de deux desdits composants au moins partiellement revêtus avec la couche noire.

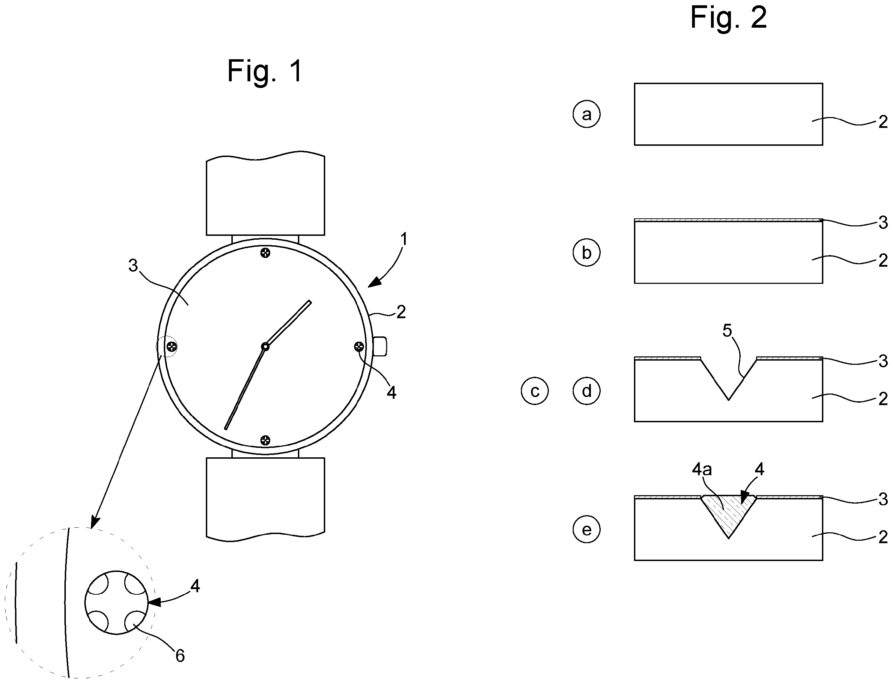

L'invention sera décrite ci-après dans le cadre d'une application à un cadran de montre 1 formé d'un substrat 2 revêtu d'une couche noire 3 tel que schématisé à la figure 1. Ledit substrat peut être réalisé dans un matériau métallique tel que l'acier, le titane, l'aluminium, un alliage de titane ou d'aluminium, le laiton ou tout autre alliage cuivreux. Il peut également être réalisé dans un matériau céramique, un cermet, en saphir, en composite ou dans un polymère. Le substrat 2 est décoré, et préférentiellement serti, avec une ou plusieurs pierres 4 réparties au sein de la couche noire 3. Il peut s'agir de pierres précieuses telles que le diamant, de pierres semi-précieuses ou encore de pierres synthétiques telles que la zircone, etc. Selon l'invention, le substrat est au moins dépourvu de la couche noire sur les portions en regard des pierres. La couche noire peut être présente de manière à affleurer la table de la pierre. Il est également envisageable de décorer le substrat avec plusieurs alignements de pierres, le substrat comportant une couche noire entre les alignements.

Le substrat 2 comporte un logement 5 schématisé à la figure 2 servant d'assise à la pierre 4 et plus particulièrement à la culasse 4a de la pierre. La fixation de la pierre au sein de l'assise est préférentiellement réalisée par sertissage à l'aide d'un élément de sertissage 6 représenté dans l'agrandissement de la figure 1. Il peut s'agir de griffes d'un chaton disposé dans le logement, de grains qui font partie intégrante du substrat, de saignées dans un logement pour un sertissage baguette ou invisible, etc. Selon l'invention, l'élément de sertissage est préférentiellement également revêtu de la couche noire de manière à réaliser un sertissage qui semble invisible aux yeux de l'utilisateur. Visuellement, celui-ci se fond dans le fond noir du cadran. En alternative, la présente invention n'exclut pas que la pierre soit collée au sein de l'assise avec une colle ne dégradant pas la brillance de la pierre.

Selon une variante de l'invention, la couche noire comporte des nanotubes de carbone. La couche de nanotubes de carbone comporte au moins 1 % en poids, de préférence au moins 10% en poids, de nanotubes de carbone. Ladite couche peut être un vernis comprenant en poids au moins 1%, de préférence au moins 10% en poids, de nanotubes de carbone. Plus la proportion est importante, plus la teinte est sombre. Dans ce vernis, les nanotubes de carbone sont dispersés aléatoirement. Ce vernis peut être déposé, à titre d'exemple, par sprayage. Alternativement, la couche comporte au moins 50%, au moins 60%, au moins 70%, au moins 80%, au moins 90% en poids de nanotubes de carbone alignés verticalement par rapport au plan du substrat, le reste étant constitué d'autres formes de carbone. De préférence, la couche comporte 100% de nanotubes de carbone alignés verticalement par rapport au plan du substrat. L'alignement vertical des nanotubes permet d'obtenir un noir plus profond par rapport à l'orientation aléatoire des nanotubes de carbone dans le vernis mais présente le désavantage d'avoir une résistance mécanique moindre que le vernis. Pour pallier cet inconvénient, une couche de protection peut être déposée sur la couche noire avec cependant pour corollaire une réduction du coefficient d'absorption de la lumière. Cette couche de protection peut être un vernis ou une couche mince d'un matériau, par exemple de l'Al₂O₃, du TiO₂ ou du SiO₂, ou un empilement de couches d'un ou plusieurs de ces matériaux déposés par ALD (pour Atomic Layer Déposition). Les nanotubes présentant une orientation verticale sont déposés par des procédés sous vide tels que le PVD (pour Physical Vapor Déposition en anglais), le CVD (pour Chemical Vapor Déposition en anglais) ou encore la synthèse par ablation laser. La couche de nanotubes de carbone a une épaisseur comprise entre 1 et 100 µm.

Selon une autre variante, la couche noire est une couche comprenant majoritairement des oxydes d'aluminium AlₓO_{y} tels que de l'Al₂O₃ avec en complément des oxydes métalliques non ferreux tels que, à titre d'exemple, des oxydes de cuivre, de zinc ou de manganèse. Cette couche comporte au minimum 90% d'AlₓO_{y}, de préférence 100% d'AlₓO_{y}. L'oxyde d'aluminium a une teneur en aluminium comprise entre 45% et 65 % massique et de préférence entre 45% et 50% massique. Cette couche a une épaisseur comprise entre 1 et 50 microns, de préférence entre 2 et 10 microns, et plus préférentiellement entre 4 et 7 microns. Elle peut être déposée par PVD ou CVD ou PECVD (pour Plasma-Enhanced Chemical Vapor Déposition en anglais).

Le composant selon l'invention peut être fabriqué selon plusieurs modes de réalisation du procédé qui sont illustrés de manière schématique aux figures 2 à 7. Par souci de simplification, les figures 2 à 7 illustrent uniquement le substrat muni d'un logement pour l'assise de la pierre sans représenter l'élément de sertissage. Toute étape faisant état de l'usinage du logement englobe, le cas échéant, la préparation mécanique de l'élément de sertissage tel que les grains.

Le procédé de fabrication du composant comporte dans un ordre non spécifié pour les étapes b) à e) :
- une étape a) de mise à disposition du substrat 2,
- une étape b) de dépôt sur le substrat 2 de la couche noire 3 ou b') de dépôt d'une couche d'un précurseur 7 comprenant des nanotubes de carbone pour la variante avec des nanotubes de carbone,
- une étape c) d'usinage du logement 5 dans ou sur le substrat 2,
- une étape d) d'enlèvement sélectif de la couche noire 3 ou d') d'enlèvement sélectif de la couche de précurseur 7 préalablement déposée sur le substrat 2, de façon à ce qu'au moins la surface du logement 5 soit dépourvue de la couche noire 3 ou de la couche de précurseur 7,
- une étape e) de positionnement et de fixation, et préférentiellement de sertissage, de la pierre 4 au sein du logement 5.

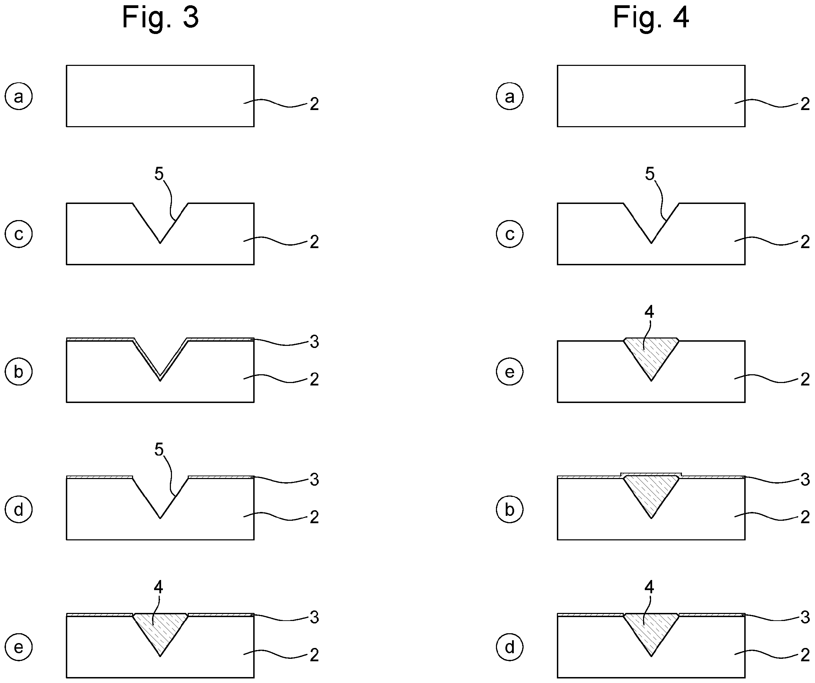

Selon un premier mode de réalisation illustré aux figures 2 à 5, le procédé de fabrication du composant comprend:
- Une étape a) de mise à disposition du substrat 2 (fig.2-5),
- Une étape b) de dépôt de la couche noire 3 sur tout ou partie du substrat 2, comprenant la zone destinée à former le logement (fig.2), le logement 5 (fig.3), ou la surface supérieure de la pierre 4, à savoir la table et la couronne pour une pierre taillée (fig.4-5),
- Une étape d) d'enlèvement sélectif de la couche noire 3 au niveau de la zone destinée à former le logement 5 (fig.2), du logement 5 (fig.3) ou de la surface supérieure de la pierre 4 (fig.4-5).

Il comprend également une étape c) d'usinage du logement 5 dans le substrat 2 et une étape e) de positionnement et de fixation de la pierre 4 sur le substrat 2. La fixation couvre le sertissage ainsi que d'autres techniques de fixation telles que le collage.

Pour la variante de la figure 2, la couche noire 3 est déposée sur le substrat 2 avant l'usinage du logement 5. Ensuite, la couche noire 3 est enlevée lors de l'usinage du logement 5, c.à.d. que les étapes c) et d) sont une seule et même étape. Pour finir, l'étape e) est réalisée.

Pour la variante de la figure 3, la couche noire 3 est déposée sur le substrat 2 après l'étape c) d'usinage du logement 5. Ensuite, la couche noire 3 est enlevée au niveau du logement 5. L'enlèvement peut être réalisé mécaniquement et plus spécifiquement manuellement à l'aide d'un outil de sertisseur. Selon une variante préférée, cet enlèvement sélectif est réalisé par ablation laser et plus préférentiellement avec un laser impulsionnel tel qu'un laser nanoseconde, picoseconde ou femtoseconde. Pour finir, l'étape e) est réalisée.

Pour la variante de la figure 4, le dépôt de la couche noire 3 est réalisé sur le substrat 2 déjà décoré avec la pierre 4. Ensuite, la couche noire 3 sur la pierre 4 est enlevée mécaniquement ou préférentiellement par ablation laser avec comme précédemment un laser impulsionnel. Cette variante de la figure 4 est préférée car après l'enlèvement sélectif de la couche noire, il n'est plus nécessaire de manipuler la surface contrairement à la variante de la figure 3 où il est encore nécessaire de sertir le substrat après l'enlèvement sélectif.

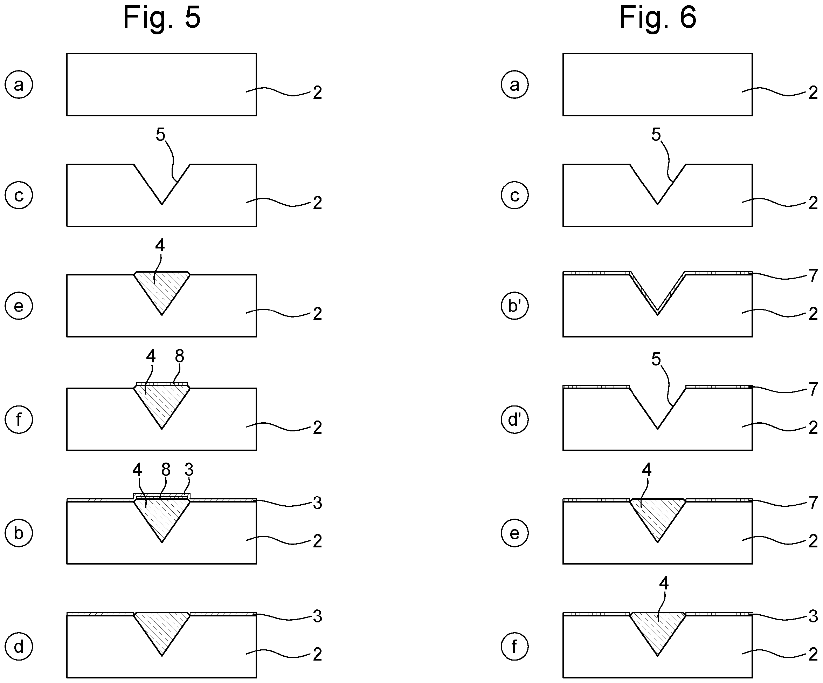

Pour la variante de la figure 5, le substrat 2 est décoré avec la pierre 4 conformément à l'étape e). Ensuite, le procédé comporte une étape f) additionnelle d'application d'un masque 8 sur la pierre 4. Le masque peut être une laque, un adhésif, un film photosensible, etc. Il peut être déposé à titre d'exemple par photolithographie, stéréolithographie, impression numérique ou manuellement pour un adhésif ou film. Ensuite, la couche noire 3 est déposée à l'étape b) sur le substrat 2, y compris sur le masque 8. Finalement, la couche noire 3 est sélectivement enlevée avec le masque 8 à l'étape d). Le masque peut être retiré par ablation laser ou mécaniquement, par exemple manuellement avec un outil dédié. De manière alternative (non représentée), le masque pourrait être positionné dans le logement avant le positionnement de la pierre. Le dépôt de la couche noire et son enlèvement sélectif sont alors réalisés avant le positionnement de la pierre.

Selon un deuxième mode de réalisation illustré à la figure 6, l'étape b) est remplacée par l'étape b') de dépôt d'une couche d'un précurseur 7 sur le substrat 2, y compris sur la surface du logement 5. L'étape b') inclut le dépôt de la couche de précurseur et le recuit pour polymériser le précurseur. Cette variante est d'application pour une couche noire à base de nanotubes de carbone. Le précurseur comporte un polymère et des nanotubes de carbone. Le pourcentage en poids de nanotubes de carbone est compris entre 0.1 et 15% et le pourcentage en poids de polymère est compris entre 85 et 99.9%. Le polymère peut être choisi parmi des thermoplastiques tels qu'un polyamide, polybutène, polyéthylène, polyimide, polypropylène, polystyrène, polyacétate de vinyle et un polyméthacrylate de méthyle ou parmi des thermodurcissables tels qu'un polyépoxyde et un polyuréthane. Pour améliorer l'adhésion entre le polymère et les nanotubes de carbone, ces derniers peuvent au préalable être fonctionnalisés. A titre d'exemple, pour une matrice en polyimide, les nanotubes de carbone peuvent être préalablement fonctionnalisés par une attaque en milieu acide, par exemple dans de l'acide nitrique. Le précurseur comprenant le mélange de nanotubes de carbone répartis dans la matrice de polyimide est déposé et polymérisé à une température comprise entre 150 et 350°C pendant un temps compris entre 1 et 7 heures.

Il y a ensuite l'étape d') d'enlèvement sélectif de la couche de précurseur 7 déposée dans le logement 5. Préférentiellement, cet enlèvement sélectif est réalisé par ablation laser mais il pourrait également être réalisé manuellement avec un outil approprié. Suit alors l'étape e) de positionnement et fixation de la pierre 4 au sein du logement 5 du substrat 2. Finalement, à l'étape f), la couche de précurseur 7 est soumise à une attaque chimique ou laser qui révèle les nanotubes de carbone de la couche de précurseur pour former la couche noire 3. L'attaque chimique peut être réalisée en milieu acide (ex. acide formique, acide acétique, acide sulfurique, acide nitrique, acide chlorhydrique, acide fluorhydrique) ou dans un solvant approprié (ex. m-cresol) selon la nature de la matrice polymère. Cette étape d'etching a pour effet de dissoudre partiellement la matrice polymère de la couche de précurseur, de créer une rugosité de surface et ainsi de révéler une microstructure riche en nanotubes de carbone et propice au piégeage de la lumière. Une attaque laser avec un laser impulsionnel (ex. femtoseconde, picoseconde) est également envisageable pour créer une telle microstructure de surface.

De manière alternative (non représentée), l'étape b') peut être réalisée avant l'étape c) d'usinage du logement, les étapes c) et d') étant alors une même étape concomitante d'usinage du logement et d'enlèvement sélectif de la couche de précurseur au niveau du logement. D'une autre manière alternative (non représentée), le dépôt de la couche de précurseur peut être réalisé sur le substrat serti avec la pierre, l'enlèvement sélectif du précurseur étant alors réalisé sur la pierre.

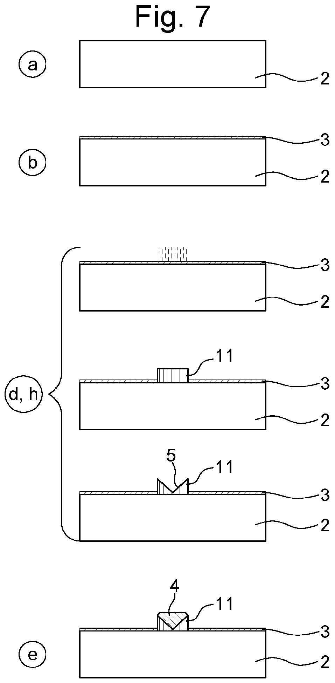

Selon un troisième mode de réalisation illustré à la figure 7, le procédé comprend une étape additionnelle h) de croissance de matière sur le substrat 2 revêtu avec la couche noire pour former un support 11 destiné à accueillir la pierre 4. Il comporte ainsi successivement :
- une étape a) de mise à disposition du substrat 2,
- une étape b) de dépôt de la couche noire 3 sur le substrat 2,
- une étape h) de croissance de matière sur le substrat 2 revêtu pour former le support 11, cette étape est concomitante à l'étape d) d'enlèvement sélectif de la couche noire 3,
- une étape e) de positionnement et fixation de la pierre 4 au sein du logement 5 ménagé sur le substrat 2 dans le support 11.

L'étape de croissance de la matière est réalisée par fabrication additive telle que l'impression numérique, par électroformage, frittage laser ou tout autre procédé additif dérivé. La matière peut être métallique, céramique ou polymérique. Lors de cette étape, la couche noire 3 va automatiquement s'enlever de manière sélective au niveau du support 11, ce qui permet de libérer le substrat 2 en regard de la pierre 4 à sertir.

Le logement 5 peut être réalisé directement lors de l'étape h) de croissance ou être usiné ultérieurement avant l'étape e).

Tous les modes de réalisation sont présentés pour un élément de sertissage qui est recouvert d'une couche noire de manière à se fondre avec le fond du cadran. Cependant, la présente invention n'exclut pas que l'enlèvement sélectif de la couche noire du logement inclue également l'élément de sertissage.

Pour finir, la présente invention couvre également un ensemble comprenant un premier composant et un second composant chacun destiné à l'habillage intérieur ou au mouvement d'une pièce d'horlogerie ou de bijouterie. Selon l'invention, le premier et le second composants comportent au moins une portion revêtue de la couche noire. Préférentiellement, le premier composant présente un mouvement relatif par rapport au second composant et est monté en regard de ce dernier. Ce premier composant est décoré avec une ou plusieurs pierres. Par exemple, le premier composant est une aiguille revêtue de la couche noire et décorée avec une pierre sertie ou collée au bout de l'aiguille, et le second composant est un cadran revêtu de la couche noire.

### Légende

(1) Cadran
(2) Substrat
(3) Couche noire
(4) Pierre
   a. Culasse
(5) Logement
(6) Elément de sertissage
(7) Couche de précurseur
(8) Masque
(11) Support

## Revendications

1. Composant d'habillage intérieur ou du mouvement pour une pièce d'horlogerie ou de bijouterie comprenant un substrat (2) revêtu partiellement d'une couche noire (3) et décoré d'au moins une pierre (4) assise dans un logement (5) ménagé dans le substrat (2) ou dans un support (11) positionné sur le substrat (2), ladite couche noire (3) comprenant des nanotubes de carbone ou de l'oxyde d'aluminium, ledit substrat (2) étant au moins dépourvu de la couche noire (3) sur la surface du logement (5).

2. Composant selon la revendication 1, **caractérisé en ce que** la couche noire (3) affleure la table de la pierre (4).

3. Composant selon l'une des revendications précédentes, **caractérisé en ce que** la pierre (4) est sertie au sein du logement (5) avec un élément de sertissage (6).

4. Composant selon la revendication précédente, **caractérisé en ce que** ledit élément de sertissage (6) est également revêtu de la couche noire (3).

5. Composant selon la revendication 1, **caractérisé en ce qu'**il comporte plusieurs alignements de pierres (4), la couche noire (3) étant disposée entre les alignements.

6. Composant selon l'une des revendications précédentes, **caractérisé en ce que** la couche noire (3) est un vernis comprenant en poids au moins 1%, de préférence au moins 10% de nanotubes de carbone, lesdits nanotubes de carbone ayant une orientation aléatoire au sein du vernis.

7. Composant selon l'une des revendications 1 à 5, **caractérisé en ce que** la couche noire (3) comporte au moins 50%, au moins 60%, au moins 70%, au moins 80%, au moins 90% en poids de nanotubes de carbone alignés verticalement par rapport au plan du substrat (2), le reste étant constitué d'autres formes de carbone.

8. Composant selon l'une des revendications 1 à 5, **caractérisé en ce que** la couche noire (3) comporte 100% en poids de nanotubes de carbone alignés verticalement par rapport au plan du substrat (2).

9. Composant selon l'une des revendications précédentes, **caractérisé en ce que** la couche noire (3) comprenant des nanotubes de carbone a une épaisseur comprise entre 1 et 100 µm.

10. Composant selon l'une des revendications 1 à 5, **caractérisé en ce que** la couche noire (3) comprend au moins 90% en poids d'oxyde d'aluminium, de préférence 100% en poids d'oxyde d'aluminium.

11. Composant selon la revendication 10, **caractérisé en ce que** l'oxyde d'aluminium a une teneur en poids en aluminium comprise entre 45% et 65% et de préférence entre 45% et 50%.

12. Composant selon la revendication 10 ou 11, **caractérisé en ce que** la couche noire (3) a une épaisseur comprise entre 1 et 50 microns, de préférence entre 2 et 10 microns, et plus préférentiellement entre 4 et 7 microns.

13. Composant selon l'une des revendications précédentes, **caractérisé en ce qu'**il est choisi parmi le groupe comprenant un cadran, un index, une aiguille, une applique, une masse oscillante, une platine et un pont.

14. Ensemble comprenant le composant selon l'une des revendications précédentes et un autre composant d'habillage intérieur ou du mouvement pour une pièce d'horlogerie ou de bijouterie, ledit autre composant étant revêtu au moins partiellement de ladite couche noire (3).

15. Ensemble selon la revendication précédente, **caractérisé en ce que** le composant est disposé en regard dudit autre composant et monté avec un mouvement relatif par rapport audit autre composant.

16. Ensemble selon la revendication 14 ou 15, **caractérisé en ce que** le composant est une aiguille et **en ce que** l'autre composant est un cadran.

17. Pièce d'horlogerie ou de bijouterie comprenant le composant selon l'une des revendications 1 à 13 ou l'ensemble selon l'une des revendications 14 à 16.

18. Procédé de fabrication d'un composant destiné à l'habillage intérieur ou au mouvement d'une pièce d'horlogerie ou de bijouterie, ledit composant comportant un substrat (2) revêtu au moins partiellement d'une couche noire (3) et décoré avec au moins une pierre (4) assise dans un logement (5) ménagé dans ou sur le substrat (2), ladite couche noire (3) comprenant des nanotubes de carbone ou de l'oxyde d'aluminium et ledit substrat (2) étant au moins dépourvu de la couche noire (3) sur la surface du logement (5), le procédé comprenant :
- une étape a) de mise à disposition du substrat (2),
suivie dans un ordre non spécifié d'
- une étape b) de dépôt de la couche noire (3) sur le substrat (2),
- une étape c) d'usinage du logement (5) dans ou sur le substrat (2),
- une étape e) de positionnement et fixation de la pierre (4) au sein du logement (5),
ledit procédé comprenant une étape additionnelle d) d'enlèvement sélectif de la couche noire (3) préalablement déposée sur le substrat (2) de manière à ce qu'au moins la surface du logement (5) soit dépourvue de la couche noire (3).

19. Procédé de fabrication selon la revendication précédente, **caractérisé en ce qu'**il comporte successivement :
- l'étape a) de mise à disposition du substrat (2),
- l'étape b) de dépôt de la couche noire (3) sur le substrat (2),
- l'étape d) d'enlèvement sélectif de la couche noire (3) au niveau du logement (5) réalisée lors de l'étape c) d'usinage du logement (5) dans le substrat (2), les étapes c) et d) étant une seule et même étape,
- l'étape e) de positionnement et fixation de la pierre (4) au sein du logement (5) du substrat (2).

20. Procédé de fabrication selon la revendication 18, **caractérisé en ce qu'**il comporte successivement :
- l'étape a) de mise à disposition du substrat (2),
- l'étape c) d'usinage du logement (5) dans le substrat (2),
- l'étape b) de dépôt de la couche noire (3) sur le substrat (2),
- l'étape d) d'enlèvement sélectif de la couche noire (3) sur la surface du logement (5),
- l'étape e) de positionnement et fixation de la pierre (4) au sein du logement (5) du substrat (2).

21. Procédé de fabrication selon la revendication 18, **caractérisé en ce qu'**il comporte successivement :
- l'étape a) de mise à disposition du substrat (2),
- l'étape c) d'usinage du logement (5) dans le substrat (2),
- l'étape e) de positionnement et fixation de la pierre (4) au sein du logement (5) du substrat (2),
- l'étape b) de dépôt de la couche noire (3) sur le substrat (2), y compris sur la surface libre de la pierre (4),
- l'étape d) d'enlèvement sélectif de la couche noire (3) déposée sur la surface libre de la pierre (4).

22. Procédé de fabrication selon la revendication 18, **caractérisé en ce qu'**il comporte successivement :
- l'étape a) de mise à disposition du substrat (2),
- l'étape c) d'usinage du logement (5) dans le substrat (2),
- l'étape e) de positionnement et fixation de la pierre (4) au sein du logement (5) du substrat (2),
- une étape f) de positionnement d'un masque (8) sur la surface libre de la pierre (4),
- l'étape b) de dépôt de la couche noire (3) sur le substrat (2), y compris sur le masque (8),
- l'étape d) d'enlèvement sélectif de la couche noire (3) via l'enlèvement du masque (8).

23. Procédé de fabrication selon la revendication 18, **caractérisé en ce qu'**il comporte successivement :
- l'étape a) de mise à disposition du substrat (2),
- l'étape c) d'usinage du logement (5) dans le substrat (2),
- une étape f) de positionnement d'un masque (8) sur la surface du logement (5),
- l'étape b) de dépôt de la couche noire (3) sur le substrat (2), y compris sur le masque (8),
- l'étape d) d'enlèvement sélectif de la couche noire (3) via l'enlèvement du masque (8),
- l'étape e) de positionnement et fixation de la pierre (4) au sein du logement (5) du substrat (2).

24. Procédé de fabrication selon la revendication 18, **caractérisé en ce qu'**il comporte successivement :
- l'étape a) de mise à disposition du substrat (2),
- l'étape b) de dépôt de la couche noire (3) sur le substrat (2),
- une étape h) de croissance de matière sur le substrat (2) pour former un support (11), ladite étape h) conduisant à un enlèvement sélectif de la couche noire (3) au niveau du support (11) sur le substrat (2) conformément à l'étape d),
- l'étape e) de positionnement et fixation de la pierre (4) au sein du logement (5) ménagé sur le substrat (2) dans le support (11).

25. Procédé de fabrication selon la revendication précédente, **caractérisé en ce que** l'étape h) de croissance de matière est réalisée par fabrication additive, par électroformage ou frittage laser.

26. Procédé de fabrication d'un composant destiné à l'habillage intérieur ou au mouvement d'une pièce d'horlogerie ou de bijouterie, ledit composant comportant un substrat (2) revêtu au moins partiellement d'une couche noire (3) et décoré avec au moins une pierre (4) assise dans un logement (5) ménagé dans le substrat (2), ladite couche noire (3) comprenant des nanotubes de carbone et ledit substrat (2) étant au moins dépourvu de la couche noire (3) sur la surface du logement (5), le procédé comprenant :
- une étape a) de mise à disposition du substrat (2),
suivie dans un ordre non spécifié d'
- une étape b') de dépôt et recuit d'une couche de précurseur (7) comprenant des nanotubes de carbone sur le substrat (2),
- une étape c) d'usinage du logement (5) dans le substrat (2),
- une étape e) de positionnement et fixation de la pierre (4) au sein du logement (5) du substrat (2),
ledit procédé comprenant une étape additionnelle d') d'enlèvement sélectif de la couche de précurseur (7) de manière à ce qu'au moins la surface du logement soit dépourvue de la couche de précurseur (7) et une étape f) d'attaque chimique ou laser de la couche de précurseur (7) pour former la couche noire (3) sur le substrat (2).

27. Procédé de fabrication selon la revendication 26, **caractérisé en ce qu'**il comporte successivement :
- l'étape a) de mise à disposition du substrat (2),
- l'étape c) d'usinage du logement (5) dans le substrat (2),
- l'étape b') de dépôt et recuit de la couche de précurseur (7) comprenant des nanotubes de carbone sur le substrat (2), y compris sur la surface du logement (5),
- l'étape d') d'enlèvement sélectif de la couche de précurseur (7) déposée sur la surface du logement (5),
- l'étape e) de positionnement et fixation de la pierre (4) au sein du logement (5) du substrat (2),
- l'étape f) d'attaque chimique ou laser de la couche de précurseur (7) pour former la couche noire (3) sur le substrat (2).

28. Procédé de fabrication selon la revendication 26, **caractérisé en ce qu'**il comporte successivement :
- l'étape a) de mise à disposition du substrat (2),
- l'étape b') de dépôt et recuit d'une couche d'un précurseur (7) sur le substrat (2),
- l'étape c) d'usinage du logement (5) dans le substrat (2) conduisant à enlever sélectivement la couche de précurseur (7) au niveau du logement (5),
- l'étape e) de positionnement et fixation de la pierre (4) au sein du logement (5) du substrat (2),
- l'étape f) d'attaque chimique ou laser de la couche de précurseur (7) pour former la couche noire (3) sur le substrat (2).

29. Procédé de fabrication selon la revendication 26, **caractérisé en ce qu'**il comporte successivement :
- l'étape a) de mise à disposition du substrat (2),
- l'étape c) d'usinage du logement (5) dans le substrat (2),
- l'étape e) de positionnement et fixation de la pierre (4) au sein du logement (5) du substrat (2),
- l'étape b') de dépôt et recuit d'une couche d'un précurseur (7) sur le substrat (2), y compris sur la surface libre de la pierre (4),
- l'étape d') d'enlèvement sélectif de la couche de précurseur (7) déposée sur la surface libre de la pierre (4),
- l'étape f) d'attaque chimique ou laser de la couche de précurseur (7) pour former la couche noire (3) sur le substrat (2).

30. Procédé de fabrication selon l'une des revendications 26 à 29, **caractérisé en ce que** le précurseur comporte un polymère et des nanotubes de carbone.

31. Procédé de fabrication selon la revendication précédente, **caractérisé en ce que** le pourcentage en poids de nanotubes de carbone est compris entre 0.1 et 15% et le pourcentage en poids de polymère est compris entre 85 et 99.9%.

32. Procédé de fabrication selon la revendication 30 ou 31, **caractérisé en ce que** le polymère est choisi parmi un polyamide, un polybutène, un polyéthylène, un polyimide, un polypropylène, un polystyrène, un polyacétate de vinyle, un polyméthacrylate de méthyle, un polyépoxyde et un polyuréthane.

33. Procédé de fabrication selon l'une des revendications 26 à 32, **caractérisé en ce que** la couche de précurseur (7) a une épaisseur comprise entre 10 et 200 microns, de préférence entre 100 et 200 microns.

34. Procédé de fabrication selon l'une des revendications 18 à 33, **caractérisé en ce que** l'étape d) ou d') d'enlèvement sélectif est réalisée par ablation laser ou mécaniquement.

35. Procédé de fabrication selon l'une des revendications 18 à 34, **caractérisé en ce que** la couche noire (3) comprenant des nanotubes de carbone est déposée par spray, PVD ou CVD.

36. Procédé de fabrication selon l'une des revendications 18 à 25, **caractérisé en ce que** la couche noire (3) comprenant de l'oxyde d'aluminium est déposée par PVD, CVD ou PECVD.

37. Procédé de fabrication selon l'une des revendications 18 à 36, **caractérisé en ce que** la fixation de la pierre (4) est réalisée par sertissage.
